# EUROPEAN PATENT APPLICATION

(11) **EP 2 284 876 A1**
(43) Date of publication of application: **16.02.2011**
(21) Application number: 09758095.5
(22) Date of filing: 02.06.2009
(51) Int. Cl.: H01L 21/60

(54) **MANUFACTURING METHOD FOR SEMICONDUCTOR DEVICE AND SEMICONDUCTOR DEVICE**

(30) Priority: 05.06.2008 JP 2008147716
(71) Applicant: Sumitomo Bakelite Co., Ltd., Shinagawa-ku Tokyo 140-0002 (JP)
(72) Inventor: KATSURAYAMA, Satoru, Tokyo 140-0002 (JP)
(74) Representative: Müller, Christian Stefan Gerd
(86) International application number: PCT/JP2009/002447
(87) International publication number: WO 2009/147828

(57) **Abstract**

A method of manufacturing a semiconductor device of the present invention includes a coating process in which a pasty thermosetting resin composition having a flux activity is coated on at least either one of a substrate and a semiconductor chip; a bonding process in which the substrate and the semiconductor chip are electrically bonded while placing the pasty thermosetting resin composition in between; a curing process in which the pasty thermosetting resin composition is cured under heating; and a cooling process, succeeding to the curing process, in which cooling is performed at a cooling rate between 10 [°C/hour] or above and 50 [°C/hour] or below.

## Description

### TECHNICAL FIELD

The present invention relates to a method of manufacturing a semiconductor device, and a semiconductor device.

### BACKGROUND ART

In recent years, semiconductor packages have widely been diversified in association with downsizing, thinning and advancement in performance. In particular, methods of surface mounting of semiconductor chips with the aid of bumps such as solder bumps, aimed at increasing transmission speed of electric signals, are diversified. As this sort of method of mounting, methods of vertically mounting the semiconductor chips using metal bumps have been investigated, in view of further accelerating transmission of electric signals.
On the other hand, interconnect design of the semiconductor chips has increasingly been shrunk to make the pitches narrower, so that structure of the semiconductor chips has consequently been complicated in order to keep necessary levels of performances, and the semiconductor chips *per* se have been becoming more brittle.
In addition, referring to recent environmental awareness, metals per se adoptable to the bumps have been becoming lead-free, making it difficult to protect the bumps.

For this reason, requirements for characteristics to be owned have been becoming severer also for encapsulation materials (underfill material) used for this sort of bump bonding, so that it is now essential to achieve bump protection and chip protection at the same time. The underfill material preferably has a large elastic modulus from the viewpoint of bump protection, whereas preferably has a small elastic modulus from the viewpoint of protecting the chips (reducing warpage of the chips). In short, the underfill material is required to have contradictory characteristics with respect to the bump protection and chip protection. To solve this problem, investigations have been made on balancing the physical characteristics of the underfill material (see Patent Documents 1 and 2, for example).

However, typically due to complication of the semiconductor packages and dimensional restriction, only a limited degree of upgrading of performances has been achievable simply by balancing the physical characteristics of the under fill material, and the situation has inevitably demanded re-designing of the structure per se, or has even put off the lead-free roadmap in order to clear a required level of reliability.

[Patent Document 1] Japnaese Laid-Open Patent Publication No. H07-335791
[Patent Document 2] Japnaese Laid-Open Patent Publication No. H10-204259

### DISCLOSURE OF THE INVENTION

The present invention is to provide a method of manufacturing a semiconductor device, capable of protecting the bumps, and of also protecting the semiconductor chip by reducing warpage.

The object described in the above may be achieved by the present invention described in (1) to (18) below.
(1) A method of manufacturing a semiconductor device substrate which includes:
   a coating process in which a pasty thermosetting resin composition having a flux activity is coated on at least either one of a substrate and a semiconductor chip;
   a bonding process in which the substrate and the semiconductor chip are electrically bonded while placing the pasty thermosetting resin composition in between;
   a curing process in which the pasty thermosetting resin composition is cured under heating; and
   a cooling process, succeeding to the curing process, in which cooling is performed at a cooling rate between 10 [°C/hour] or above, and 50 [°C/hour] or below.
(2) The method of manufacturing a Semiconductor device as described in (1),
   wherein, assuming that the curing temperature of the pasty thermosetting resin composition in the curing process as Tc [°C], in the cooling process, said step of cooling is performed at said cooling rate between Tc [°C] or below and down to (Tc-90) [°C] or above.
(3) The method of manufacturing a semiconductor device as described in (2),
   wherein, assuming that the curing temperature (Tc) as 150 [°C], in the cooling process , said step of cooling is performed at said cooling rate between 150 [°C] or above and 60 [°C] or below.
(4) The method of manufacturing a semiconductor device as described in (2),
   wherein said step of cooling is performed at said cooling rate between 60 [°C/hour] or above, and 120 [°C/hour] or below, in the temperature range lower than (Tc-90) [°C].
(5) The method of manufacturing a semiconductor device as described in (1),
   wherein linear coefficient of expansion (α1) of the substrate in the thickness-wise direction thereof, in the range from 25°C or above, up to glass transition temperature (Tg) or below, is 20 ppm/°C or smaller.
(6) The method of manufacturing a semiconductor device as described in (1),
   wherein linear coefficient of expansion (α1) of the substrate in the thickness-wise direction thereof, in the range from 25°C or above, up to glass transition temperature (Tg) or below, is 5 ppm/°C or larger.
(7) The method of manufacturing a semiconductor device as described in (1),
   wherein the glass transition temperature of a cured product of the pasty thermosetting resin composition after the curing process is 50°C or above and 150°C or below.
(8) The method of manufacturing a semiconductor device as described in (2),
   wherein the glass transition temperature of a cured product of the pasty thermosetting resin composition after the curing process is 50°C or above and 150°C or below.
(9) The method of manufacturing a semiconductor device as described in (8),
   wherein, in the cooling process, said step of cooling is performed at said cooling rate between Tc [°C] or below and (the glass transition temperature of a cured product of the pasty thermosetting resin composition minus 20) [°C] or above.
(10) The method of manufacturing a semiconductor device as described in (1),
   wherein linear coefficient of expansion of a cured product of the pasty thermosetting resin composition after the curing process, over the range from 25°C or above, up to the glass transition temperature (Tg) or below, is 5 ppm/°C or larger, and 60 ppm/°C or smaller.
(11) The method of manufacturing a semiconductor device as described in (1),
   wherein, in the cooling process, the cooling rate is 25 [°C/hour] or below.
(12) The method of manufacturing a semiconductor device as described in (1),
   using the substrate having a first electro-conductive portion, and the semiconductor chip having a second electro-conductive portion,
   in the bonding process, the substrate and the semiconductor chip are electrically bonded, while being covered with the pasty thermosetting resin composition, so as to connect the first electro-conductive portion and the second electro-conductive portion with a solder.
(13) The method of manufacturing a semiconductor device as described in (12),
   wherein at least either one of the first electro-conductive portion and the second electro-conductive portion is composed of solder bumps.
(14) The method of manufacturing a semiconductor device as described in (1),
   wherein the pasty thermosetting resin composition contains a thermosetting resin and a flux activating agent.
(15) The method of manufacturing a semiconductor device as described in (14),
   wherein content of the thermosetting resin is 5% by weight or more, and 70% by weight or less of the whole portion of the pasty thermosetting resin composition.
(16) The method of manufacturing a semiconductor device as described in (14),
   wherein content of the flux activating agent is 0.1% by weight or more, and 50% by weight or less of the whole portion of the pasty thermosetting resin composition.
(17) The method of manufacturing a semiconductor device as described in (14),
   wherein the flux activating agent has a carboxyl group and a phenolic hydroxyl group in the molecule thereof.
(18) A. semiconductor device obtained by the method of manufacturing a semiconductor device described in any one of (1) to (17).

According to the present invention, there is provided a method of manufacturing a semiconductor device, capable of protecting the bumps, and of also protecting the semiconductor chip by reducing warpage.

### BRIEF DESCRIPTION OF THE DRAWINGS

The above and other objects, features and advantages of the present invention will be more apparent from the following description of certain preferred embodiments taken in conjunction with the accompanying drawings.
FIG. 1 is a sectional view illustrating an exemplary method of manufacturing a semiconductor device.
FIG. 2 is a sectional view illustrating an exemplary method of manufacturing a semiconductor device.
FIG. 3 is a sectional view illustrating an exemplary method of manufacturing a semiconductor device.
FIG. 4 is a sectional view illustrating an exemplary method of manufacturing a semiconductor device.
FIG. 5 is a sectional view illustrating an exemplary method of manufacturing a semiconductor device.

### BEST MODES FOR CARRYING OUT THE INVENTION

The method of manufacturing a semiconductor device of the present invention will be detailed below.
The method of manufacturing a semiconductor device of the present invention has a coating process in which a pasty thermosetting resin composition having a flux activity is coated on at least either one of a substrate and a semiconductor chip; a bonding process in which the substrate and the semiconductor chip are electrically bonded while placing the pasty thermosetting resin composition in between; a curing process in which the pasty thermosetting resin composition is cured under heating; and a cooling process, succeeding to the curing process, in which cooling is performed at a cooling rate of 10 [°C/hour] or above, and 50 [°C/hour] or below (note that [°C/hour] may occasionally be expressed as [°C/h]).

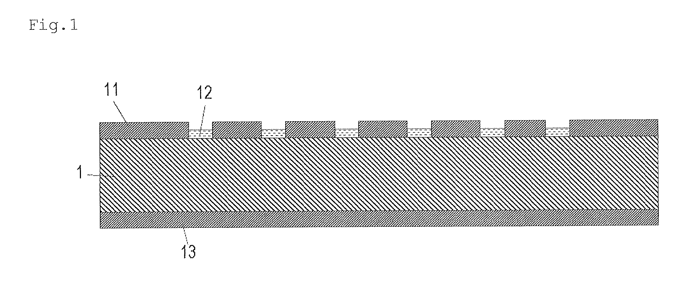

FIGs. 1 to 5 are drawings schematically illustrating a method of manufacturing a semiconductor device of the present invention.
The method of manufacturing a semiconductor device of the present invention will be explained below.
First, as illustrated in FIG. 1, a substrate 1 (circuit substrate) is prepared. The substrate 1 has an interconnect pattern 11 formed on one surface thereof (on the top side in FIG. 1), and electrode pad portions 12 are arranged. On the other surface of the substrate 1 (on the bottom side in FIG. 1), an electro-conductive material layer 13 is provided so as to allow therein formation of circuits in the later process.

While the coefficient of thermal expansion of the substrate 1 in the thickness-wise direction, in the range from 25°C or above, up to the glass transition temperature (Tg) or below, is not specifically limited, it is preferably 20 ppm/°C or smaller, and particularly preferably 5 to 18 ppm/°C (expression of numerical range using "to", hereinafter, is defined to include the upper and lower limit values, unless otherwise specifically noted). By adjusting the coefficient in this range, stress possibly produced due to difference in the linear coefficients of expansion between the chip and the substrate may be suppressed, and thereby the warpage may more effectively be suppressed.

Possible methods for obtaining such substrate 1 may be exemplified by a method of mixing a large amount of inorganic filler into a resin composition which composes the substrate 1, a method of using a material having a large elastic modulus for composing the substrate 1, and so forth.

### (Coating Process)

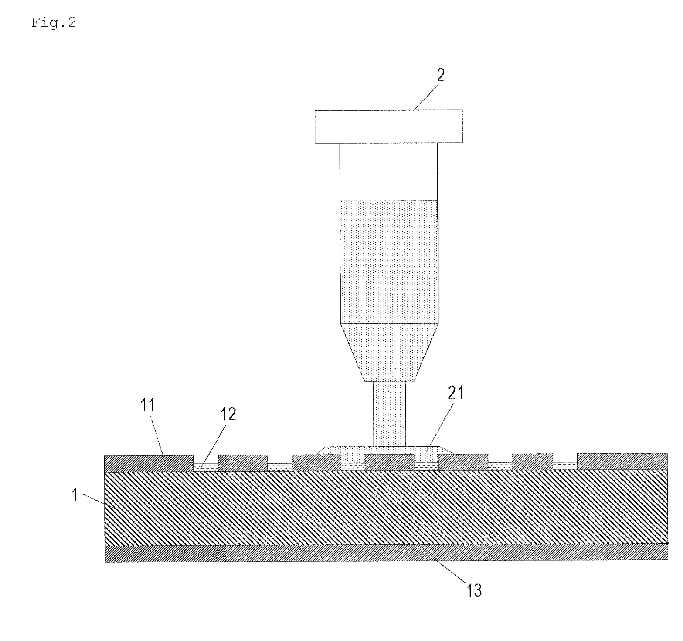

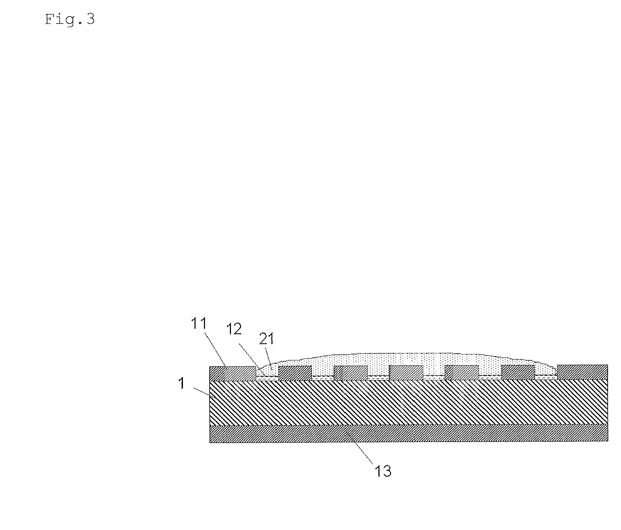

Next, a pasty thermosetting resin composition 21 having a flux activity is coated, so as to cover the electrode pad portions 12 on the substrate 1 (FIG. 2, FIG. 3). While methods of coating are not specifically limited, a syringe 2 may be used as illustrated in FIG. 2.
While amount of coating of the pasty thermosetting resin composition 21 having a flux activity is not specifically limited, it may be good enough if at least the electrode pad portions 12 (sites of bonding) are covered typically as illustrated in FIG. 3.
The pasty thermosetting resin composition 21 having a flux activity may be exemplified by a resin composition containing a thermosetting resin and a flux activating agent.

As the thermosetting resign, any of publicly-known thermosetting resins, such as an epoxy resin, a cyanate resin, a bismaleimide resin, an urethane resin, a polybutadiene resin, a silicone resin, a phenol resin, an urea resin, a melamine resin, an unsaturated polyester resin, an alkyd resin and so forth, may be adoptable. The epoxy resin is more preferable. Since the thermosetting resin herein is used for the purpose of encapsulating the semiconductor chip, those containing less amount of impurities, in particular ionic impurities, are preferable.

Specific examples of the epoxy resin include bisphenol-type epoxy resins such as a bisphenol A-type epoxy resin, a bisphenol F-type epoxy resin, a bisphenol AD-type epoxy resin, and a bisphenol E-type epoxy resin; novolac-type epoxy resins such as a phenol novolac-type epoxy resin, and a cresol novolac-type epoxy resin; aromatic glycidyl amine-type epoxy resins such as a N,N-diglycidyl aniline, a N,N-diglycidyl toluidine, a diamino diphenylmethane-type glycidylamine, and an aminophenol-type glycidylamine; a hydroquinone-type epoxy resin; biphenyl-type epoxy resins such as a biphenylaralkyl-type epoxy resin; a stilbene-type epoxy resin; a triphenolmethane-type epoxy resin; a triphenol propane-type epoxy resin; an alkyl-modified triphenolmethane-type epoxy resin; a triazine-core-containing epoxy resin; a dicyclopentadiene-modified phenolic epoxy resin; a naphthol-type epoxy resin; naphthalene-type epoxy resin; a phenolaralkyl-type epoxy resins having a phenylene and/or a biphenylene skeleton; epoxy resins such as aralkyl-type epoxy resins such as a naphthol aralkyl-type epoxy resin having a phenylene and/or a biphenylene skeleton; a vinylcyclohexene dioxide; a dicyclopentadiene oxide; aliphatic epoxy resins such as alicyclic epoxys such as an alicyclic diepoxy-adipate; and bromine-containing epoxy resins.

While content of the thermosetting resin (epoxy resin) is not specifically limited, it may preferably be 5 to 70% by weight, and particularly preferably 10 to 50% by weight, of the whole portion of the pasty thermosetting resin composition 21. By adjusting the content into the ranges described in the above, the pasty thermosetting resin composition 21 will be excellent particularly in thermal and mechanical characteristics including glass transition temperature, elastic modulus, and so forth.

The flux activating agent refers to as a substance which exhibits an action of reducing oxide film on metal surface, to thereby expose the metal surface (flux action).
The flux activating agent may be exemplified by phenolic compounds, acid or acid anhydride compounds, amine compounds, amide compounds, imidazoles, and activated rosin.
The phenolic compounds may be exemplified by tetramethyl bisphenol A, catechol, resorcine, hydroquinone, xylenol, bisphenol. A, bisphenol F, bisphenol AP, bisphenol S, bisphenol Z, dimethyl bisphenol A, dimethyl bisphenol F, tetramethyl bisphenol A, tetrame-thyl bisphenol F, biphenol, tetramethyl biphenol, dihydroxyphenyl ether, dihydroxybenzophenone, *o*-hydroxyphenol, *m*-hydroxyphenol, *p*-hydroxyphenol, polyphenols such as a phenol novolac resin and an orthocresol novolac resin, trisphenols such as a trihydroxy phenylmethane, and phenols having a naphthalene skeleton.

The acid or acid anhydride compounds may be exemplified by formic acid, acetic acid, propionic acid, butyric acid, valeric acid, caproic acid, enanthic acid, caprylic acid, pelargonic acid, capric acid, lauric acid, myristic acid, palmitic acid, margaric acid, stearic acid, oleic acid, linoleic acid, linolenic acid, arachidonic acid, docosahexaenoic acid, eicosapentaenoic acid, oxalic acid, malonic acid, succinic acid, benzoic acid, phthalic acid, isophthalic acid, terephthalic acid, salicylic acid, gallic acid, mellitic acid, cinnamic acid, pyruvic acid, lactic acid, malic acid, citric acid, fumaric acid, maleic acid, aconitic acid, glutaric acid, adipic acid, pimelic acid, suberic acid, azelaic acid, sebacic acid, amino acid, nitrocarboxylic acid, abietic acid, phthalic anhydride, trimellitic anhydride, pyromellitic anhydride, maleic anhydride, benzophenone tetracarboxylic anhydride, ethylene glycol bistrimellitate, het anhydride, tetrabromophthalic anhydride, tetrahydrophthalic anhydride, methyl tetrahydrophthalic anhydride, methyl nadic anhydride, hexahydrophthalic anhydride, methyl hexahydrophthalic anhydride, dodecyl succinic anhhydride, polyadipic anhydride, polyazelaic anhydride, polysebacic anhydride, poly(ethyl octadecanedioic)anhydride, poly(phenylhexadecanedioic)anhydride, methylhimic anhydride, trialkyl tetrahydrophthalic anhydride, and methyl cyclohexene dicarboxylic anhydride.

Also compounds having both of a phenolic hydroxyl group and a carboxyl group may be adoptable. Specific examples include 2,3-dihydroxybenzoic acid, 2,4-dihydroxybenzoic acid, 2,5-dihydroxybenzoic acid, 2,6-dihydroxybenzoic acid, 3,4-dihydroxybenzoic acid, gallic acid, 1,4-dihydroxy-2-naphthoic acid, 3,5-dihydroxy-2-naphthoic acid, 3,7-dihydroxy-2-naphthoic acid, phenolphthalein, and diphenolic acid.

The amine compounds may be exemplified by ethylenediamine, 1,3-diaminopropane, 1,4-diaminobutane, diethylenetriamine, triethylenetetramine, tetraethylenepentamine, pentaethylenehexamine, dipropylendiamine, diethylaminopropylamine, tri(methylamino)hexane, dimethylaminopropylamine, diethylaminopropylamine, methyliminobis(propylamine), hexamethylenediamine, diaminodiphenylmethane, diaminodiphenylsulfone, isophoronediamine, menthenediamine, isophoronediamine, bis(4-amino-3-methyldicyclohexyl)methane, diaminodicyclohexyl methane, N-aminoethylpiperadine, 3,9-bis(3-aminopropyl)-2,4,8,10-tetraoxaspiro(5,5)undecane, 2,5-dimethyl hexamethylenediamine, trimethyl hexamethylenediamine, iminobis(propylamine), bis(hexamethyle)triamine, *m*-xylenediamine, meta-phenylenediamine, diaminodiethylphenyl methane, and polyetherdiamine.

The amide compounds may be exemplified by dicyanediamide, and polyamide resin synthesized by dimer of linolenic acid and ethylenediamine.
The imidazoles may be exemplified, by 2-methylimidazole, 2-ethyl-4-methylimidazole, 2-undecylimidazole, 2-heptadecylimidazole, 2-phenyl-4,5-dihydroxy methylimidazole, 2-phenylimidazole, 2-ethylimidazole, and 2-ethyl-4-methylimidazole.
These compounds may be used not only as a flux activating agent, and those crosslinkable with epoxy resin may be used also as a curing agent.

While content of the flux activating agent is not specifically limited, it is preferably 0.1 to 50% by weight, and in particular 1 to 40% by weight, of the whole portion of the pasty thermosetting resin composition 21. By adjusting the content in the above-described ranges, the flux activating agent can exhibit an excellent flux activity. In particular for the case where the flux activating agent is used also as a curing agent, the pasty thermosetting resin composition 21 can be ensured with excellent thermal and mechanical characteristics such as glass transition temperature and elastic modulus, and also with an excellent curing property.

Among these flux activating agent, those compounds having redox activity, contributive to curing reaction with thermosetting resin such as epoxy resin, and can be incorporated into the cross-linkage structure (curing agent having a flux activity) are preferable. With these compounds, cleaning of flux is no longer necessary, and thereby the pasty thermosetting resin composition 21 may be improved in the long-term reliability.
The curing agent having a flux activity may be exemplified by phenolic compounds, acid anhydrides, imidazoles, and compounds having both of a phenolic hydroxyl group and a carboxyl group.

The pasty thermosetting resin composition 21 having a flux activity may contain additives such as a curing agent, a filler and a coupling agent, besides the above-described thermosetting resin and the flux activating agent.
The filler may be exemplified by inorganic fillers which include silicates such as talc, calcined clay, uncalcined clay, mica and glass; oxides such as titanium oxide, alumina, and silica powders such as fused silica (fused spherical silica, fused crushed silica), synthetic silica and crystalline silica; carbonates such as calcium carbonate, magnesium carbonate and hydrotalcite; hydroxides such as aluminum hydroxide, magnesium hydroxide and calcium hydroxide; sulfates or sulfites such as barium sulfate, calcium sulfate and calcium sulfate; borates such as zinc borate, barium metaborate, aluminum borate, calcium borate and sodium borate; and nitrides such as aluminum nitride, boron nitride and silicon nitride. Also organic fillers may be adoptable. Among these, fused silica, crystalline silica and synthetic silica are preferable, in view of their possibilities of improving reliabilities such as heat resistance, moisture resistance and strength of liquid encapsulation resin composition. While geometry of the filler is not specifically limited, spherical geometry is preferable from the viewpoint of viscosity and fluidization characteristics.

While content of the filler is not specifically limited, it is preferably 20 to 90% by weight, and in particular 30 to 85% by weight, of the whole portion of the pasty thermosetting resin composition 21. The content smaller than the above-described lower limit value may reduce an effect of improving reliabilities such as lowering the coefficient of linear expansion or lowering water absorption, whereas the content larger than the above-described upper limit value may increase viscosity of the thermosetting resin composition, and may consequently degrade the work efficiency and bump bonding performance.

The coupling agent may be exemplified by vinyl trichlorosilane, vinyl trimethoxysilane, vinyl triethoxysilane, vinyl tri(β-methoxyethoxy)silane, (β-(3,4-epoxycyclohexyl)ethyl trimethoxysilane, γ-acryloxypropylmethyl dimethoxysilane, γ-acryloxypropyl trimethoxysilane, γ-acryloxypropylmethyl diethoxysilane, γ-acryloxypropyl triethoxysilane, γ-methacryloxypropylmethyl dimethoxysilane, γ-methacryloxypropyl trimethoxysilane, γ-methacryloxypropylmethyl diethoxysilane, γ-methacryloxypropyl triethoxysilane, γ-glycidoxypropyl trimethoxysilane, γ-glycidoxypropyl trimethoxysilane, γ-glycidoxypropylmethyl diethoxysilane, γ-glycidoxypropyl triethoxysilane, *p*-styryl trimethoxysilane, N-(β-aminoethyl-γ-aminopropylmethyl)dimethoxysilane, N-(γ-aminoethyl-γ-aminopropyl)trimethoxysilane, N-(β-aminoethyl-γ-aminopropyl)triethoxysilane, γ-aminopropyl triethoxysilane, and γ-phenyl-γ-aminopropyl trimethoxysilane. These compounds may be used independently, or may be used in a form of mixture. Among these coupling agent, amine terminal-type silane coupling agents are preferable. By the selection, the fluidity and adhesiveness may be improved.

While content of the coupling agent is not specifically limited, it is preferably 0.1 to 20% by weight, and in particular 0.3 to 10% by weight, of the whole portion of the pasty thermosetting resin composition 21. The content smaller than the above-described lower limit value may degrade the adhesiveness or fluidity, whereas the content exceeding the above-described upper limit value may increase formation of volatile-induced voids.

### (Bonding Process)

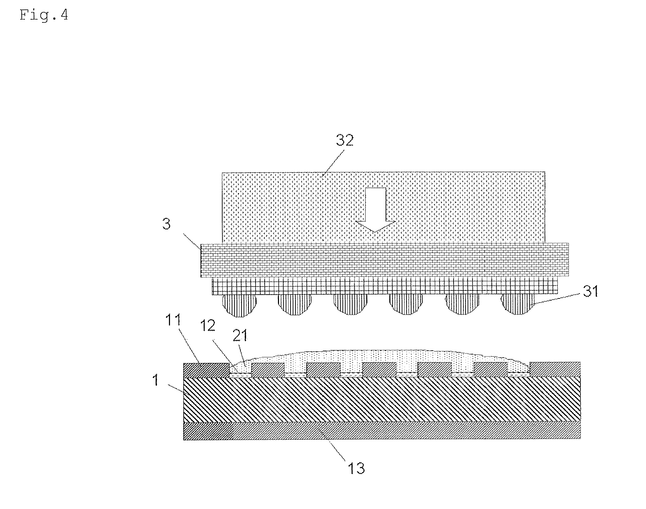

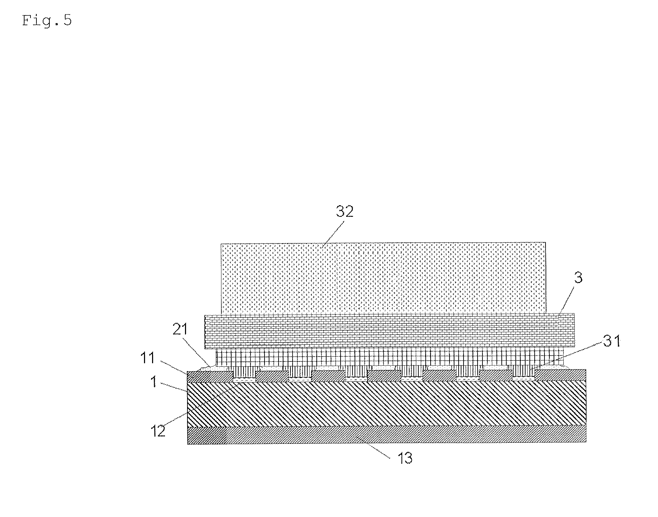

Next, a semiconductor chip 3 is mounted on the substrate 1 using a flip-chip bonder 32. In this process, the semiconductor chip 3 is mounted while aligning solder bumps 31 (first electro-conductive portion) thereof with the electrode pad portions 12 (second electro-conductive portion) of the substrate 1 so as to bring them into contact (FIG. 4). In the process of mounting, the solder bumps 31 are melted and electrically bonded to the electrode pad portions 12. Since the pasty thermosetting resin composition 21 herein has a flux activity, the solder-assisted bonding may proceed while removing the oxide film on the surface of the solder bumps 31 (FIG. 5). In other words, in this process of bonding, the substrate 1 and the semiconductor chip 3 are electrically bonded, so that the solder bumps 31 and the electrode pad portions 12 are bonded by solder, while being covered with the pasty thermosetting resin composition 21.

While conditions of bonding are not specifically limited, it may be preferable to set temperature of the flip-chip bonder 32 higher by 10°C to 100°C than the melting point of the solder material used for the solder bumps 31, and to heat the solder bumps 31 for 1 to 30 seconds. In this process, the heating is more preferably effected only from the semiconductor chip 3 side. By this way of heating, thermal stress otherwise possibly be applied to the substrate may be reduced, warpage of the semiconductor device otherwise possibly occurs due to difference in the linear coefficients of expansion between the substrate and the chip may be reduced, and also the volatile-induced voids ascribable to the substrate may be suppressed.
In this embodiment, the first electro-conductive portion and the second electro-conductive portion are not limited to the solder bumps 31 and the electrode pad portions 12, respectively, and it may be good enough that at least either one represents the solder bumps, or alternatively, the both may represent the solder bumps.

### (Curing Process)

The pasty thermosetting resin composition 21 is then heated and cured. In this way, a gap between the solder bumps 31 and the electrode pad portions 12 may be filled up, and thereby reliability of bonding may be improved. While a means of heating and curing of the pasty thermosetting resin composition 21 is not specifically limited, an oven may typically be used.
While conditions of heating depend on the thermosetting resin to be used, and are therefore not specifically limited, the heating may preferably be conducted at 100 to 200°C for 30 to 180 minutes, and particularly preferably at 120 to 170°C for 60 to 150 minutes. The temperature of heating is set not lower than the glass transition temperature of a cured product of the pasty thermosetting resin composition 21.

While the glass transition temperature of a cured product of the pasty thermosetting resin composition 21 having a flux activity, after the curing, is not specifically limited, it may preferably be 20°C to 300°C, and in particular 50°C to 150°C. By adjusting the glass transition temperature to the above-described lower limit value or higher, the bumps may more effectively be protected. On the other hand, by adjusting the glass transition temperature to the above-described upper limit value or lower, a fillet composed of the pasty thermosetting resin composition 21 having a flux activity, formed after bonding of the substrate 1 and the semiconductor chip 3, may effectively be prevented from cracking.

While average linear coefficient of expansion (α1), in the range from 25°C or above up to the glass transition temperature or below, of the cured product of the pasty thermosetting resin composition 21 having a flux activity after the curing process is not specifically limited, it is preferably 5 ppm/°C to 60 ppm/°C, and in particular 15 ppm/°C to 40 ppm/°C. By adjusting the glass transition temperature in the above-described ranges, the average linear coefficient of expansion of the cured product of the pasty thermosetting resin composition 21 having a flux activity, in the range not higher than the glass transition temperature, may be brought closer to the linear coefficient of expansion of the bumps (solder bumps 31). Accordingly, the bumps may effectively be prevented from cracking.

The glass transition temperature and the linear coefficient of expansion of the pasty thermosetting resin composition 21 having a flux activity, after the curing process, may be measured according to a method descried below.
The pasty thermosetting resin composition 21 having a flux activity is allowed to cure at 150°C for 3 hours, to thereby manufacture a 4 mm×4 mm×10 mm sample. Next, using a TMA device (from SII), the glass transition temperature, and the average linear coefficient of expansion in the range not higher than the glass transition temperature, are calculated under a compressive load of 10 g, at a rate of temperature elevation of 10°C/min., over the range of measurement temperature from -100°C to 300°C.

### (Cooling Process)

Next, after the curing process, the thermosetting resin composition is cooled at a cooling rate of 10 to 50 °C/h. A means of cooling adopted herein is such as succeedingly using the same oven having been used in the curing process, and setting conditions of cooling in the oven. The cooling rate may be constant or variable. The cooping rate may be calculated typically by dividing difference of temperature, which is obtained by subtracting temperature after the end of cooling process from temperature of atmosphere immediately after the curing process, by the cooling time. The temperature herein means, for example, temperature of the atmosphere in the oven.
By cooling the thermosetting resin composition at a cooling rate of 10 to 50°C/h (first cooling rate) as described in the above, in particular at a constant cooling rate, the stress in the process of cooling may be moderated, and thereby the warpage may be reduced.

In one example of the process of manufacturing a semiconductor device of related art, as described in Patent Document 2, the semiconductor device has been obtained by carrying out soldering in a reflow oven, and then by curing a thermosetting resin, placed between a semiconductor chip and a wiring board, under heating at 120°C, without carrying out the cooling process. As described in the above, from the viewpoint of productivity, the semiconductor device has been taken out immediately after the curing, and exposed to room temperature. The semiconductor device is therefore abruptly cooled, at a cooling rate of at least 100°C/h or above. The thermosetting resin, which is a viscoelastic product, then causes thermal distribution over the deep inner portion towards the surficial portion, and thereby produces residual stress. In other words, the constituent materials cause heat shrinkage due to abrupt cooling, and consequently a large stress produces due to large difference in the linear coefficients of expansion of the individual constituent materials. As described in the above, the process of manufacturing a semiconductor device of related art has inevitably resulted in warpage, due to abrupt cooling.

In contrast, in the process of manufacturing a semiconductor device of the present invention, the cooling process is adopted as described in the above. The cooling at a cooling rate of 10 to 50°C/h, carried out in succession to the curing process, may moderate the mode of thermal shrinkage, and may further moderate the stress ascribable to difference in the linear coefficients of expansion of the constituent materials. Accordingly, the present invention may successfully moderate the stress in the process of cooling, to thereby reduce the warpage.

The lower limit value of the cooling rate (first cooling rate) is preferably 15 °C/h or above, and more preferably 20°C/h or above. On the other hand, the upper limit value of the cooling rate (first cooling rate) is preferably 40°C/h or below, and more preferably 30°C/h or below. By adjusting the cooling rate to the above-described lower limit value or above, the warpage may be suppressed in a more improved manner. On the other hand, by adjusting the cooling rate to the above-described upper limit value or below, the warpage may be suppressed in a more improved manner.

While, in the cooling process, temperature range over which the cooling rate is controlled (occasionally referred to as control range, hereinafter) is not specifically limited, it may be set to Tc [°C] or below, and (Tc-90) [°C] or above, assuming that the curing temperature of the pasty thermosetting resin composition 21 in the curing process as Tc [°C]. The cooling is preferably performed at the above-described first cooling rate over the above-described temperature range. By this way of cooling, the generated stress may be more distinctively reduced in the control range, and by controlling the temperature range, the warpage may be suppressed in a more improved manner.

The control range of the first cooling rate may more specifically set to 150 to 60 [°C] while assuming the curing temperature (Tc) as 150 [°C], and more preferably 150 to 80 [°C]. The cooling is preferably performed at the above-described first cooling rate over the above-described temperature range. In particular, the control range may be set to Tc [°C] or below, and (glass transition temperature of a cured product of the pasty thermosetting resin composition 21, minus 20) [°C] or above, and more specifically to 150 to (glass transition temperature (Tg) of a cured product of the pasty thermosetting resin composition 21, minus 20) [°C]. The cooling is preferably performed at the above-described first cooling rate over the above-described temperature range. The control range set to the above-described range is particularly excellent in view of suppressing the warpage.

The cooling rate out of the above-described control range may be defined as a second cooling rate. While the second cooling rate out of the above-described control range (in particular in the temperature range typically below (Tc-90) [°C]) is not specifically limited, it is preferably set to 60 to 120°C/h, and particularly preferably to 40 to 100°C/h. By the setting, an effect of moderating the stress and a good productivity may be achieved in a well-balanced manner.

The above-described processes are followed by a process of forming solder bumps used for connection with a mother board, a process of mounting components and so forth, and thereby the semiconductor device may be obtained. The semiconductor device obtained in this way can protect the semiconductor chip, through protection of the bumps and suppression of the warpage.

### [Examples]

The present invention will be detailed below, referring to Examples and Comparative Examples, while ensuring that the present invention is not limited thereto.

### (Example 1)

### 1. Preparation of Pasty Thermosetting Resin Composition

A pasty thermosetting resin composition was obtained by weighing 70.9% by weight of bisphenol F-type epoxy resin (from DIC Corpoartion, EXA-830LVP, epoxy equivalent weight=161) as the thermosetting resin, 21.3% by weight of phenol novolac (from Sumitomo Durez Co., Ltd., PR-51470, softening point=110°C) as the curing agent, 7.1% by weight of phenolphthalein (Tokyo Chemical Industry Co., Ltd. (m.p.235°C)) as the flux activating agent, and. 0.7% by weight of 2-phenyl -4-methylimidazole (from Shikoku Chemicals Corporation, 2P4MZ) as a curing accelerator, and by dispersing the mixture under kneading using a three-roll mill, followed by defoaming *in vacuo*.

### 2. Manufacturing of Semiconductor Device

The above-described pasty thermosetting resin composition was coated on a circuit substrate having a circuit pattern formed thereon (with a core material made of ELC-4785GS from Sumitomo Bakelite Co., Ltd., having coefficients of thermal expansion (below Tg) of 11 ppm in the XY-direction, and 16 ppm in the Z-direction), and a semiconductor chip (15 mm long, 15 mm wide, and 0.725 mm thick), having solder bumps formed thereon, was mounted using a flip-chip bonder under heating at 260°C for 10 seconds. The pasty thermosetting resin composition was then cured under heating in a oven at 150°C for 120 minutes.
The cooling was then performed at a cooling rate of 25°C/h over the control range from 150 down to 60°C, by setting condition of the oven relevant to the cooling rate, followed by cooling at a rate of approximately 60°C/h down to 30°C or around, to thereby obtain the semiconductor device. Note that the temperature herein means temperature of the atmosphere in the oven.

### (Example 2)

The processes of manufacturing a semiconductor device were conducted similarly as described in Example 1, except that the cooling rate was set as described below.
The cooling was conducted over the range from 150 down to 60°C, at a cooling rate of 15°C/h.

### (Example 3)

The processes of manufacturing a semiconductor device were conducted similarly as described in Example 1, except that the range of cooling was set as described below.
The cooling was conducted at the cooling rate same as that in Example 1 over the range from 150 down to 80°C, and at a cooling rate of 1°C/min over the range from not higher than 80°C down to 30°C.

### (Example 4)

The processes of manufacturing a semiconductor device were conducted similarly as described in Example 1, except that the materials below were used as the pasty thermosetting resin composition.
A pasty thermosetting resin composition was obtained by weighing 76.3% by weight of bisphenol F-type epoxy resin (EXA-830LVP from DIC Corporation, epoxy equivalent weight=161) as the thermosetting resin, 22.9% by weight of 2,5-dihydroxybenzoic acid (from Tokyo Chemical Industry Co., Ltd. (m.p.=200 to 205°C)) as the curing agent having a flux activity, and 0.8% by weight of 2-phenyl-4-methylimidazole (from Shikoku Chemicals Corporation) as the curing accelerator, and by dispersing the mixture under kneading using a three-roll mill, followed by defoaming *in vacuo*.

### (Example 5)

The processes of manufacturing a semiconductor device were conducted similarly as described in Example 1, except that the pasty thermosetting resin composition was coated not onto the substrate, instead onto the semiconductor chip.

### (Example 6)

The processes of manufacturing a semiconductor device were conducted similarly as described in Example 1, except that the substrate described below was used.
As the substrate, the one having a core composed of BT (CCL-HL832HS from Mitsubishi Gas Chemical Company, Inc., having coefficients of thermal expansion (Tg or below) of 15 ppm in the XY-direction, and 55 ppm in the Z-direction) was used.

### (Comparative Example 1)

The process of manufacturing a semiconductor device was conducted similarly as described in Example 1, except that the cooling rate was set to as described below.
The cooling was conducted over the range from 150 down to 60°C, at a cooling rate of 5°C/h.

### (Comparative Example 2)

In the process of manufacturing a semiconductor device, the pasty thermosetting resin composition described below was injected to a substrate having a semiconductor chip preliminarily mounted thereon, to thereby obtain a semiconductor package.
The pasty thermosetting resin composition was obtained by weighing 79.4% by weight of bisphenol F-type epoxy resin (EXA-830LVP from DIC Corporation, epoxy equivalent weight=161) as the thermosetting resin, 19.8% by weight of phenol novolac as the curing agent, and 0.8% by weight of 2-phenyl-4-methylimidazole (from Shikoku Chemicals Corporation) as the curing accelerator, and by dispersing the mixture under kneading using a three-roll mill, followed by defoaming *in vacuo.*

In addition, after the curing process, the semiconductor device was kept in the oven while keeping the curing temperature, and then taken out to immediately expose it to room temperature, and warpage of the semiconductor device was evaluated. Since the curing temperature herein was 150°C, the room temperature was 25°C, and the cooling time was 30 minutes or around, the semiconductor device was supposed to be cooled at a cooling rate of approximately 250°C/h or above. By the evaluation based on visual observation, the semiconductor device was found to cause warpage.

The semiconductor devices obtained in the individual Examples and Comparative Examples were evaluated with respect to the items below. The items of evaluation and the criteria are shown. Results are shown in Table 1.

### 1. Warpage of Semiconductor Device

Warpage of the obtained semiconductor devices, and warpage of the semiconductor device after the reflow resistance test described later were evaluated. Explanations of the marks are as follow:
A: the amount of warpage did not exceed 80 µm;
B: the amount of warpage exceeded 80 µm, but did not exceed 100 µm;
C: the amount of warpage exceeded 100 µm, but did not exceed 120 µm; and
D: the amount of warpage exceeded 120 µm.

### 2. Reliability

Reliability of the semiconductor devices was evaluated based on separation property and bonding property of the semiconductor device, after being subjected to reflow resistance test conforming to JEDEC level 3, under which SMT reflow was conducted (three times) at a peak temperature of 260°C. The evaluation was made under n=20. Explanations of the marks are as follow.

### Separation Property

A: separation was not observed for all samples;
B: incidence of separation was smaller than 5%;
C: incidence of separation was 5% or larger, and smaller than 10%; and
D: incidence of separation was 10% or larger.

### Bonding Property

A: ratio of bonding was 100%;
B: ratio of bonding was smaller than 100% (8/10 or larger), and 95% or larger (2/10 or smaller);
C: ratio of bonding exceeded 80%, and smaller than 95%; and
D: ratio of bonding was 80% or smaller.

### 3. Work Efficiency

Work efficiency was evaluated, assuming the number of labor unit in Comparative Example 2 as a reference (100). Explanations of the marks are as follow:
A: number of labor unit was 50 or larger, and 75 or smaller;
B: number of labor unit exceeded 75, and 95 or smaller;
C: number of labor unit exceeded 95, and 105 or smaller; and
D: number of labor unit exceeded 105, and 150 or smaller.

### 4. Glass Transition Temperature and Linear Coefficient of Expansion of Cured Products of Pasty Thermosetting Resin Compositions

The pasty thermosetting resin compositions obtained in Examples were cured at 150°C for 3 hours, to thereby manufacture samples having a size of 4 mm×4 mm×10 mm. Glass transition temperature, and average linear coefficient of expansion in the temperature range not higher than the glass transition temperature were calculated, using a TMA apparatus (from SII), under a compressive load of 10 g, at a rate of temperature elevation of 10°C/min., over the range of measurement temperature from -100°C to 300°C.

**[Table 1]**

| | | Example 1 | Example 2 | Example 3 | Example 4 | Example 5 | Example 6 | Comparative Example 1 | Comparative Example 2 |
|---|---|---|---|---|---|---|---|---|---|
| resin | Thermosetting Bisphenol-F type epoxy resin | 70.9 | 70.9 | 70.9 | 76.3 | 70.9 | 70.9 | 70.9 | 79.4 |
| Curing agent | Phenol novolac | 21.3 | 21.3 | 21.3 | 0.0 | 21.3 | 21.3 | 21.3 | 19.8 |
| Flux | Phenolphthalein | 7.1 | 7.1 | 7.1 | 0.0 | 7.1 | 7.1 | 7.1 | 0.0 |
| activating agent | 2,5-Dihydroxy benzoic acid | 0.0 | 0.0 | 0.0 | 22.9 | 0.0 | 0.0 | 0.0 | 0_{.}0 |
| Curing accele-rator | 2-Phenyl-4-methyl imidazole | 0.7 | 0.7 | 0.7 | 0.8 | 0.7 | 0.7 | 0.7 | 0.8 |
| Pasty thermosetting | Glass transition temperature | 110 | 110 | 110 | 90 | 110 | 110 | 110 | 110 |
| resin composition | Linear coefficient of expansion α1 (ppm/°C) | 55 | 55 | 55 | 60 | 55 | 55 | 55 | 55 |
| Cooling rate (°C/h) | | 25 | 15 | 25 | 25 | 25 | 25 | 5 | 25 |
| Range of cooling | | 150-60 | 150-60 | 150-80 | 150-60 | 150-60 | 150-60 | 150-60 | 150-60 |
| Warpage (after curing) | | A | A | B | A | A | B | C | C |
| Warpage (after reflow resistance test) | | B | B | B | B | A | B | D | D |
| Reliability (separation property) | | A | A | A | A | A | B | C | C |
| Reliability (bonding property) | | A | A | A | B | A | B | C | B |
| Work efficiency [0060] | | 70 | 75 | 65 | 70 | 70 | 70 | 80 | 100 |

As is clear from Table 1, the semiconductor devices obtained in Examples 1 to 6 were found to show only small warpage in both stages of as-manufactured and as-tested for reflow resistance.
Examples 1 to 6 were also found to be excellent in the reliability. This suggested that the solder bumps were protected.
Examples 1 to 6 were also found to be excellent in the work efficiency.

## Claims

1. A method of manufacturing a semiconductor device substrate comprising:
a coating process in which a pasty thermosetting resin composition having a flux activity is coated on at least either one of a substrate and a semiconductor chip;
a bonding process in which said substrate and said semiconductor chip are electrically bonded while placing said pasty thermosetting resin composition in between;
a curing process in which said pasty thermosetting resin composition is cured under heating; and
a cooling process, succeeding to said curing process, in which cooling is performed at a cooling rate between 10 [°C/hour] or above and 50 [°C/hour] or below.

2. The method of manufacturing a semiconductor device as claimed in Claim 1,
wherein, assuming that the curing temperature of said pasty thermosetting resin composition in said curing process as Tc [°C], in said cooling process, said step of cooling is performed at said cooling rate between Tc [°C] or below and (Tc-90) [°C] or above.

3. The method of manufacturing a semiconductor device as claimed in Claim 2,
wherein, assuming that the curing temperature (Tc) as 150 [°C], in said cooling process, said step of cooling is performed at said cooling rate between 150 [°C] or above and 60 [°C] or below.

4. The method of manufacturing a semiconductor device as claimed in Claim 2,
wherein said step of cooling is performed at a cooling rate between 60 [°C/hour] or above and 120 [°C/hour] or below, in the temperature range lower than (Tc-90) [°C].

5. The method of manufacturing a semiconductor device as claimed in Claim 1,
wherein linear coefficient of expansion (α1) of said substrate in the thickness-wise direction thereof, in the range from 25°C or above, up to glass transition temperature (Tg) or below, is 20 ppm/°C or smaller.

6. The method of manufacturing a semiconductor device as claimed in Claim 1,
wherein linear coefficient of expansion (α1) of said substrate in the thickness-wise direction thereof, in the range from 25°C or above, up to glass transition temperature (Tg) or below, is 5 ppm/°C or larger.

7. The method of manufacturing a semiconductor device as claimed in Claim 1,
wherein the glass transition temperature of a cured product of said pasty thermosetting resin composition after said curing process is 50°C or above and 150°C or below.

8. The method of manufacturing a semiconductor device as claimed in Claim 2,
wherein the glass transition temperature of a cured product of said pasty thermosetting resin composition after said curing process is 50°C or above and 150°C or below.

9. The method of manufacturing a semiconductor device as claimed in Claim 8,
wherein, in said cooling process, said step of cooling is performed at said cooling rate between Tc [°C] or below and (said glass transition temperature of a cured product of said pasty thermosetting resin composition minus 20) [°C] or above.

10. The method of manufacturing a semiconductor device as claimed in Claim 1,
wherein linear coefficient of expansion of a cured product of said pasty thermosetting resin composition after said curing process, over the range from 25°C or above, up to the glass transition temperature (Tg) or below, is 5 ppm/°C or larger, and 60 ppm/°C or smaller.

11. The method of manufacturing a semiconductor device as claimed in Claim 1,
wherein, in said cooling process, said cooling rate is 25 [°C/hour] or below.

12. The method of manufacturing a semiconductor device as claimed in Claim 1,
using said substrate having a first electro-conductive portion, and said semiconductor chip having a second electro-conductive portion,
in said bonding process, said substrate and said semiconductor chip are electrically bonded, while being covered with said pasty thermosetting resin composition, so as to connect said first electro-conductive portion and said second electro-conductive portion with a solder.

13. The method of manufacturing a semiconductor device as claimed in Claim 12,
wherein at least either one of said first electro-conductive portion and said second electro-conductive portion is composed of solder bumps.

14. The method of manufacturing a semiconductor device as claimed in Claim 1,
wherein said pasty thermosetting resin composition contains a thermosetting resin and a flux activating agent.

15. The method of manufacturing a semiconductor device as claimed in Claim 14,
wherein content of said thermosetting resin is 5% by weight or more, and 70% by weight or less of the whole portion of said pasty thermosetting resin composition.

16. The method of manufacturing a semiconductor device as claimed in Claim 14,
wherein content of said flux activating agent is 0.1% by weight or more, and 50% by weight or less of the whole portion of said pasty thermosetting resin composition.

17. The method of manufacturing a semiconductor device as claimed in Claim 14,
wherein said flux activating agent has a carboxyl group and a phenolic hydroxyl group in the molecule thereof.

18. A semiconductor device obtained by the method of manufacturing a semiconductor device as claimed in any one of Claims 1 to 17.
